# EUROPEAN PATENT SPECIFICATION

(11) **EP 3 540 737 B1**
(45) Date of publication and mention of the grant of the patent: **30.12.2020**
(21) Application number: 19160145.9
(22) Date of filing: 28.02.2019
(51) Int. Cl.: G11C 13/00, G11C 8/06, G11C 8/10, H03K 19/0175, H03K 19/0185

(54) **LEVEL SHIFTER CIRCUIT HAVING IMPROVED EFFICIENCY AND TWO-DOMAIN LEVEL SHIFTING CAPABILITY, IN PARTICULAR FOR USE IN A MEMORY DEVICE**
PEGELSCHIEBERSCHALTUNG MIT VERBESSERTER EFFIZIENZ UND PEGELVERSCHIEBUNGSFÄHIGKEIT IN ZWEI BEREICHEN, INSBESONDERE ZUR VERWENDUNG IN EINER SPEICHERVORRICHTUNG
CIRCUIT DE DÉCALAGE DE NIVEAU AYANT UNE MEILLEURE EFFICACITÉ ET UNE CAPACITÉ ACCRUE DE DÉCALAGE DE NIVEAU À DEUX DOMAINES, EN PARTICULIER POUR UNE UTILISATION DANS UN DISPOSITIF DE MÉMOIRE

(30) Priority: 15.03.2018 IT 201800003622
(43) Date of publication of application: 18.09.2019
(73) Proprietor: STMicroelectronics S.r.l., 20864 Agrate Brianza (MB) (IT)
(72) Inventor: CONTE, Antonino, 95030 TREMESTIERI ETNEO (CT) (IT); MARINO, Leopoldo Maria, 90135 PALERMO (IT); PERRONI, Maurizio Francesco, 98054 FURNARI (ME) (IT); POLIZZI, Salvatore, 90141 PALERMO (IT)
(74) Representative: Nannucci, Lorenzo

(56) References cited:
- US-A1- 2002 080 651
- US-A1- 2002 180 508
- US-A1- 2018 061 495

## Description

The present solution relates to a level shifter circuit having improved efficiency, in particular for use in a memory device, and to a corresponding memory device, in particular of a non-volatile type.

As it is known, level shifter circuits (in short, level shifters) have several applications, wherever it is required to interface two or more circuits operating at different voltage levels.

Level shifters are used in non-volatile memory devices, for example of a PCM (Phase-Change Memory) type, where storage of information is obtained by exploiting phase-change materials (e.g. "chalcogenides" or "chalcogenic materials"), having the property of switching between phases that have resistivity of considerably different value.

In these memory devices, an internal supply voltage is present (the so-called logic supply voltage V_{dd}, with low voltage values, for example comprised between 1 V and 1.35 V). In order to perform reading and writing (programming or erasing) operations on the contents of the memory cells, use of higher operating voltages, for example up to values of 4.5 V, is required.

Due to the different ranges of values of the voltages present in these memory devices, use of level shifter circuits is required, in order to interface and operatively couple low-voltage and high-voltage circuit portions.

In particular, it is often required to have two distinct level-shifted voltage domains, i.e. a medium-voltage domain (with voltages in the range between a ground reference and a medium, or intermediate, voltage level, e.g. 2.25 V) and a high-voltage domain (with voltages in the range between the medium voltage level and a high voltage level, e.g. 4.5 V).

For example, in non-volatile memory application, particularly in PCM memories, row and column decoders require voltages shifted in the medium-voltage and high-voltage domains for their operation (as will also be discussed in the following).

US 2002/180508 A1, US 2002/080651 A1 and US 2018/061495 disclose known level-shifter circuits for use in semiconductor memory devices Document US 2002/180508 discloses the preamble of claim 1.

Common desired requirements for the level shifters, particularly for memory applications, are fast level transitions, low power consumption and small area occupation.

It is also a desired requirement that level shifting operations in the medium-voltage and high-voltage domains are performed in parallel, with minimum delays between the level transitions, for example in order to avoid current cross-conductions in corresponding NMOS and PMOS transistors. Another common desired requirement is for the level shifter to offer flexibility as regards the supply voltage values that may be applied.

The present Applicant has realized that known level shifters solutions are not satisfactory in meeting the above requirements.

The aim of the present solution is to solve the problems highlighted previously, and in particular to provide an improved solution for a level shifter circuit.

According to the present invention, a level shifter circuit, and a corresponding memory device are consequently provided as defined in the annexed claims.

For a better understanding of the present invention, preferred embodiments thereof are now described, purely by way of non-limiting example and with reference to the attached drawings, wherein:
- Figure 1 shows a schematic block diagram of a level shifter circuit according to an embodiment of the present solution;
- Figure 2 shows a possible circuit configuration of an input stage for medium voltage level shifting operations in the level shifter circuit of Figure 1;
- Figure 3 shows a detailed circuit diagram of a high-voltage level shifter stage in the level shifter circuit of Figure 1;
- Figures 4A-4B and 5A-5B show plots of electrical quantities related to operation of the high-voltage level shifter stage;
- Figure 6 shows a detailed circuit diagram of a reset buffer stage in the level shifter circuit of Figure 1;
- Figures 7A-7D show plots of electrical quantities related to operation of the reset buffer stage;
- Figure 8 shows a block diagram of a memory device using the level shifter circuit of Figure 1, in corresponding address-decoder stages;
- Figure 9A is a schematic depiction of a portion of a column decoder in the memory device of Figure 8; and
- Figure 9B is a schematic depiction of a portion of a row decoder in the memory device of Figure 8.

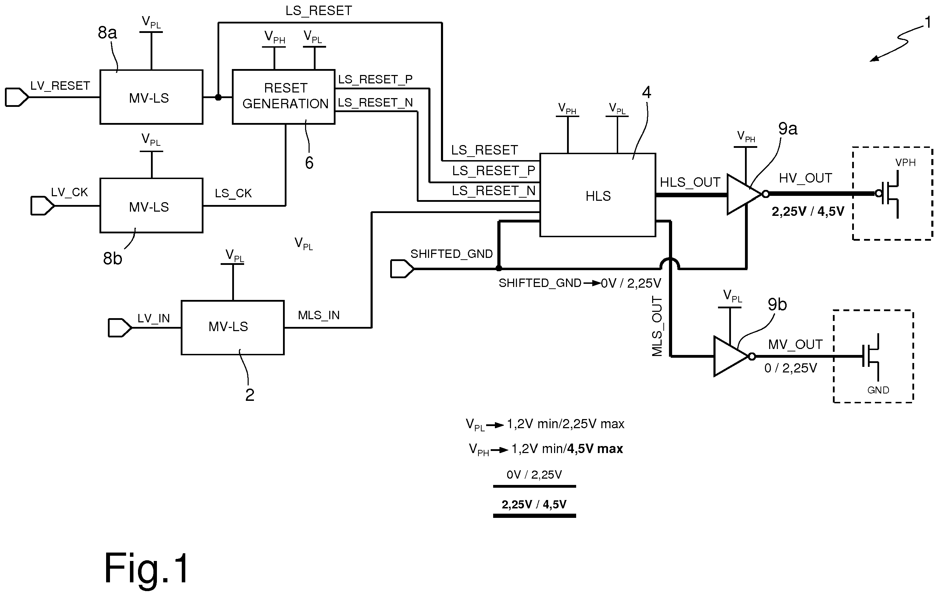

With initial reference to Figure 1, an embodiment of a level shifter circuit, designated as a whole by 1, is now described.

The level shifter circuit 1 comprises an input stage 2, which receives an input signal LV_IN at a low voltage level, i.e. in a range [GND, V_{dd}], where V_{dd} is a logic supply voltage with a value that is for example comprised between 1 V and 1.35 V; and provides at the output a medium level shifted input voltage MLS_IN, in the medium-voltage domain, with voltages in the range [GND, V_{PL}], between the ground reference GND and an intermediate supply voltage V_{PL} at medium voltage, with a value greater than the logic supply voltage V_{dd}, for example comprised between 1.2 V and 2.25 V (in the exemplary application for a non-volatile memory, the value of the intermediate supply voltage V_{PL} may depend on the memory operation being performed, being it a reading or a writing operation).

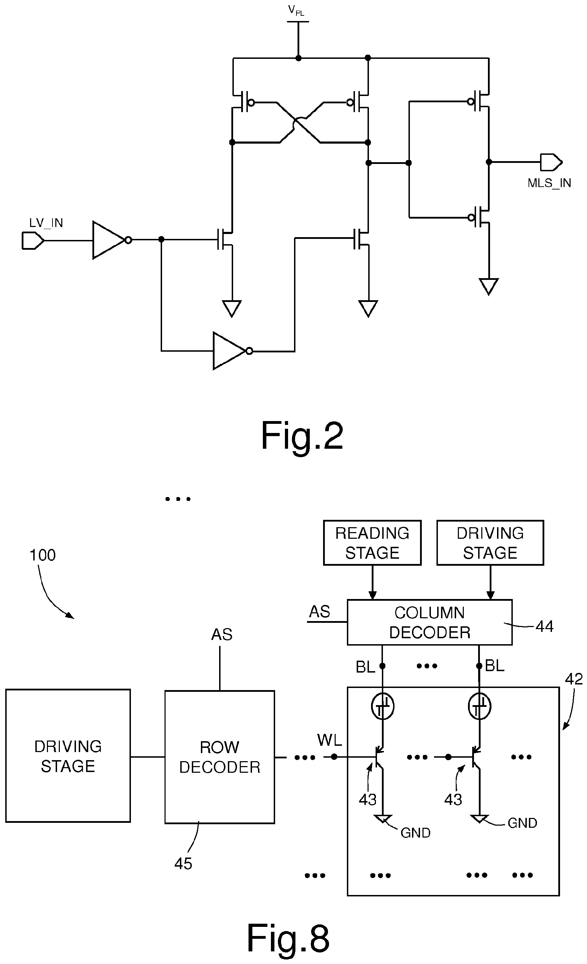

The input stage 2 implements a medium voltage shifting of the input signal LV_IN, and may have any known circuit configuration suitable for medium voltage shifting. For example, Figure 2 shows a possible circuit configuration (here not disclosed in detail) for the input stage 2, implementing medium-voltage level shifting of the input signal LV_IN to generate the corresponding medium-level shifted input voltage MLS_IN.

The level shifter circuit 1 further comprises (see again Figure 1) a high-level shifting stage 4, having a signal input receiving the medium-level shifted input voltage MLS_IN, and a first output providing a corresponding high-level shifted output voltage HLS_OUT, in the range [V_{PL}, V_{PH}], between the intermediate supply voltage V_{PL} and a high supply voltage V_{PH}, at a high voltage level with a value greater than the intermediate supply voltage V_{PL}, for example comprised between 1.2 V and 4.5 V (in the exemplary application for a non-volatile memory, also the value of the high supply voltage V_{PH} may depend on the memory operation being performed, being it a reading or a writing operation). The high-level shifting stage 4 thus has: a first supply input, receiving the intermediate supply voltage V_{PL} and a second supply input receiving the high supply voltage V_{PH}; and moreover a shifted-ground input, receiving a level-shifted ground reference SHIFTED_GND, having a voltage value higher than the ground reference GND, in the present embodiment equal to 2.25 V.

According to an aspect of the present solution, the high-level shifting stage 4 also has a second output providing a corresponding medium-level shifted output voltage MLS_OUT, in the range [GND, V_{PL}], which has corresponding and substantially simultaneous transitions as the high-level shifted output voltage HLS_OUT.

Moreover, the high-level shifting stage 4 has: a first reset input, receiving a level shifted input reset signal LS_RESET, in the medium-voltage domain [GND, V_{PL}]; a second reset input, receiving a first high-level shifted input reset signal LS_RESET_P, in the high-voltage domain [V_{PL}, V_{PH}]; and a third reset input, receiving a second high-level shifted input reset signal LS_RESET_N, also in the high-voltage domain [V_{PL}, V_{PH}], with opposite level transitions with respect to the first high-level shifted input reset signal LS_RESET_P.

The level shifter circuit 1 further comprises a reset generation stage 6, having an input receiving the level shifted input reset signal LS_RESET, and configured to perform high-level shifting operations to generate at a first reset output the first high-level shifted input reset signal LS_RESET_P, and at a second reset output the second high-level shifted input reset signal LS_RESET_N, both having transitions corresponding to the level shifted input reset signal LS_RESET; the reset generation stage 6 also has respective first and a second supply inputs receiving the intermediate supply voltage V_{PL} and, respectively, the high supply voltage V_{PH}, and moreover a clock input, receiving a level-shifted clock signal LS_CK, as a timing signal, also being in the medium-voltage domain [GND, V_{PL}].

In particular, the level shifted input reset signal LS_RESET is generated by a first medium-voltage shifting stage 8a, which receives at an input a low-voltage input reset signal LV_RESET; and the level-shifted clock signal LS_CK is generated by a second medium-voltage shifting stage 8b, which receives at a respective input a low-voltage input clock signal LV_CK (both first and second medium-voltage shifting stages 8a, 8b can be implemented in any known manner, for example with a circuit corresponding to that shown in Figure 2).

In the embodiment shown in Figure 1, the level shifter circuit 1 moreover comprises: a first inverting stage 9a, supplied by the high supply voltage V_{PH}, that receives the high-level shifted output voltage HLS_OUT from the high-level shifting stage 4 and provides, at a first output terminal of the same level shifter circuit 1, a first output voltage HV_OUT, with transitions in the high-voltage domain [V_{PL}, V_{PH}] (in the example, switching between 2.25 V and 4.5 V); and a second inverting stage 9b, supplied by the intermediate supply voltage V_{PL}, that receives the medium-level shifted output voltage MLS_OUT from the same high-level shifting stage 4 and provides, at a second output terminal of the same level shifter circuit 1, a second output voltage MV_OUT, with corresponding and simultaneous transitions in the medium-voltage domain [GND, V_{PL}] (in the example, switching between 0 V and 2.25 V).

As schematically shown, the first output voltage HV_OUT can be provided, for example, to the base terminal of a PMOS transistor, having a conduction terminal coupled to the high supply voltage V_{PH}, to switch the same PMOS transistor in a ON or OFF state; in a corresponding manner, the second output voltage MV_OUT can be provided, for example, to the base terminal of a NMOS transistor, having a conduction terminal coupled to the ground reference GND, to switch the same NMOS transistor in a ON or OFF state.

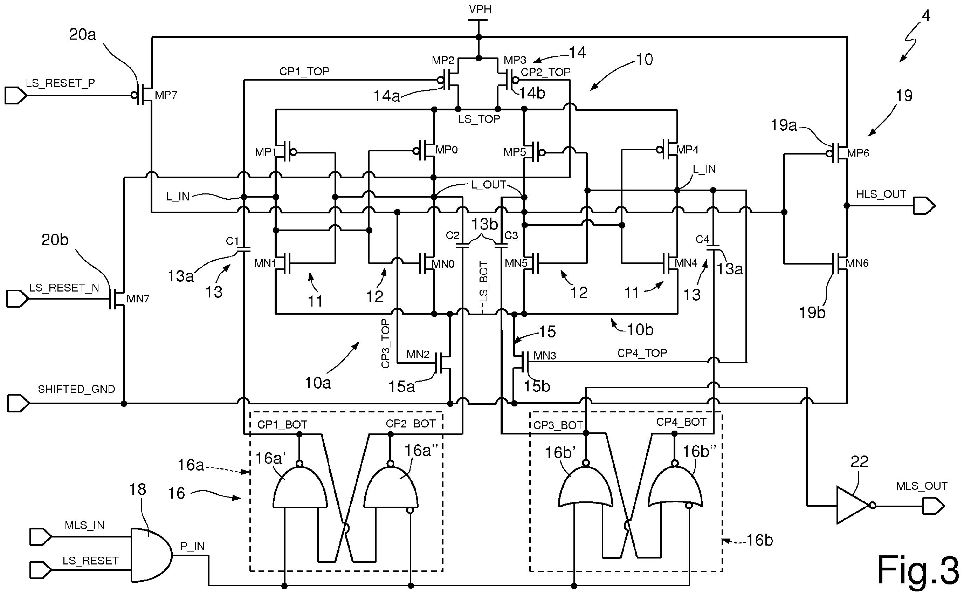

With reference to Figure 3, an embodiment of the high level shifting stage 4 is now discussed in greater details.

The high level shifting stage 4 includes a latching (or holding) core 10, which is configured to switch its latching state in response to the transitions of the medium level shifted input voltage MLS_IN and to maintain the latching state until a next transition of the same medium level shifted input voltage MLS_IN, or a reset input, is received.

The latching core 10 includes a first and a second latching units 10a, 10b, each comprising a respective first and second latch inverters 11, 12, cross-coupled between a respective latching input L_IN and a respective latching output L_OUT and having a first biasing input and a second biasing input, coupled to a top level-shifted line LS_TOP and, respectively, a bottom level-shifted line LS_BOT.

Each of the first and second inverters 11, 12 includes a respective couple of NMOS and PMOS transistors (denoted as MN0-MP0 and MN1-MP1 for the first latching unit 10a and as MN4-MP4 and MN5-MP5 for the second latching unit 10b), with first conduction terminals coupled to the bottom level-shifted line LS_BOT and the top level-shifted line LS_TOP, second conduction terminals coupled together and to the latching output L_OUT or latching input L_IN, and gate terminals coupled together and to the latching output L_OUT or latching input L_IN.

The high level shifting stage 4 further includes a capacitive-coupling unit 13 for each latching unit 10a, 10b, comprising a first coupling capacitor 13a, having a top plate coupled to the latching input L_IN of the respective latching unit 10a, 10b, and a second coupling capacitor 13b, having a top plate coupled to the latching output L_OUT of the respective latching unit 10a, 10b.

The high level shifting stage 4 moreover comprises a first and a second decoupling units 14, 15, the first decoupling unit 14 operable to selectively couple/decouple the top level-shifted line LS_TOP to/from a line set at the high supply voltage V_{PH}, and the second decoupling unit 15 operable to selectively couple/decouple the bottom level-shifted line LS_BOT to/from a line set at the level-shifted ground reference SHIFTED_GND.

In particular, the first decoupling unit 14 includes a first and a second PMOS decoupling transistors 14a, 14b coupled between the top level-shifted line LS_TOP and the line at the high supply voltage V_{PH} and having gate, or control, terminals coupled to the top plate of the first coupling capacitor 13a and, respectively, to the top plate of the second coupling capacitor 13b of the capacitive-coupling unit 13 coupled to the first latching unit 10a, receiving respective biasing signals CP1_TOP, CP2_TOP.

In a corresponding manner, the second decoupling unit 15 includes a first and a second NMOS decoupling transistors 15a, 15b coupled between the bottom level-shifted line LS_BOT and the line at the level-shifted ground reference SHIFTED_GND and having gate, or control, terminals coupled to the top plate of the first coupling capacitor 13a and, respectively, to the top plate of the second coupling capacitor 13b of the capacitive-coupling unit 13 coupled to the second latching unit 10b, receiving respective biasing signals CP3_TOP, CP4_TOP.

The high level shifting stage 4 further comprises a driving stage 16 including a first and a second driving units 16a, 16b, of a logic type, the first driving unit 16a being configured to bias the bottom plates of the first and second coupling capacitors 13a, 13b of the first latching unit 10a with respective biasing signals CP1_BOT, CP2_BOT; and the second driving unit 16b being configured to drive the bottom plates of the first and second coupling capacitors 13a, 13b of the second latching unit 10b with respective biasing signals CP3_BOT, CP4_BOT.

The first and second coupling capacitors 13a, 13b of the first and second latching units 10a, 10b thus capacitively couple the latching input L_IN and the latching output L_OUT of the respective latching unit 10a, 10b to output lines of the driving stage 16 carrying the biasing signals CP1_BOT-CP4_BOT (in particular to the output lines of the first and, respectively, second driving units 16a, 16b carrying the biasing signals CP1_BOT, CP2_BOT, respectively CP3_BOT, CP4_BOT.

According to a particular aspect of the present solution, the first and second driving units 16a, 16b are configured to generate the respective biasing signals CP1_BOT, CP2_BOT and CP3_BOT, CP4_BOT, having overlapping values during switching of the medium level shifted input voltage MLS_IN (i.e. in response to shifting of the value of the input signal LV_IN).

In particular, the first driving unit 16a is of the NAND logic type and is configured to generate the respective biasing signals CP1_BOT, CP2_BOT with positive overlapping values during switching of the medium level shifted input voltage MLS_IN, so as to drive (as will also be detailed in the following) the gate terminals of the first and second PMOS decoupling transistors 14a, 14b of the first decoupling unit 14 both at a high value (corresponding to the high supply voltage V_{PH}), thus turning off the same PMOS decoupling transistors 14a, 14b and decoupling the top level-shifted line LS_TOP from the line at the high supply voltage V_{PH} during switching of the medium level shifted input voltage MLS_IN.

In a corresponding manner, the second driving unit 16b is of the NOR logic type and is configured to generate the respective biasing signals CP3_BOT, CP4_BOT with negative overlapping values during switching of the medium level shifted input voltage MLS_IN, so as to drive (as will also be detailed in the following) the gate terminals of the first and second NMOS decoupling transistors 15a, 15b of the second decoupling unit 15 both at a low value (corresponding to the level-shifted ground reference SHIFTED_GND), thus turning off the same NMOS decoupling transistors 15a, 15b and decoupling the bottom level-shifted line LS_BOT from the line at the level-shifted ground reference SHIFTED_GND during switching of the medium level shifted input voltage MLS_IN.

Both the first and the second driving units 16a, 16b receive a common biasing (or polarization) input P_IN, which is generated at the output of a AND logic gate 18, receiving at its inputs the medium level shifted input voltage MLS_IN and the level shifted input reset signal LS_RESET.

In more details, the first driving unit 16a includes a first and a second NAND logic gates 16a', 16a", wherein: the first NAND logic gate 16a' has a first input coupled to the output of the AND logic gate 18 receiving the biasing input P_IN, a second input coupled to the output of the second NAND logic gate 16a", and an output coupled to the bottom plate of the first coupling capacitor 13a of the first latching unit 10a; and the second NAND logic gate 16a" has a first, negated, input coupled to the output of the AND logic gate 18 and receiving the negated biasing input, a second input coupled to the output of the first NAND logic gate 16a', and an output coupled to the bottom plate of the second coupling capacitor 13b of the first latching unit 10a.

The second driving unit 16b includes a first and a second NOR logic gates 16b', 16b", wherein: the first NOR logic gate 16b' has a first input coupled to the output of the AND logic gate 18 and receiving the biasing input P_IN, a second input coupled to the output of the second NOR logic gate 16b", and an output coupled to the bottom plate of the first coupling capacitor 13a of the second latching unit 10b; and the second NOR logic gate 16b" has a first, negated, input coupled to the output of the AND logic gate 18 and receiving the negated biasing input, a second input coupled to the output of the first NOR logic gate 16b', and an output coupled to the bottom plate of the second coupling capacitor 13b of the second latching unit 10b.

The high-level shifting stage 4 further comprises an output inverter unit 19, having an input coupled to the latching output L_OUT of the second latching unit 10b (and to the top plate of the second coupling capacitor 13b of the second latching unit 10b), and an output defining the first output of the high-level shifting stage 4 providing the high-level shifted output voltage HLS_OUT.

In more details, the output inverter unit 19 includes a PMOS transistor 19a, having a first conduction terminal coupled to the line at the high supply voltage V_{PH}, a second conduction terminal coupled to the first output of the high-level shifting stage 4, and a gate terminal coupled to the top plate of the second coupling capacitor 13b of the second latching unit 10b and receiving the control signals CP3_TOP; and a NMOS transistor 19b, having a first conduction terminal coupled to the line at the level-shifted ground reference SHIFTED_GND, a second conduction terminal coupled to the first output of the high-level shifting stage 4, and a gate terminal coupled to the top plate of the second coupling capacitor 13b of the second latching unit 10b and receiving the same control signals CP3_TOP.

Moreover, the high-level shifting stage 4 comprises: a first reset transistor 20a, of the PMOS type, having a first conduction terminal coupled to the line at the high supply voltage V_{PH}, a second conduction terminal coupled to the latching output L_OUT of the second latching unit 10b (and to the top plate of the second coupling capacitor 13b of the same second latching unit 10b), and a gate terminal coupled to the second reset input of the high-level shifting stage 4, receiving the first high-level shifted input reset signal LS_RESET_P; and a second reset transistor 20b, of the NMOS type, having a first conduction terminal coupled to the line at the level-shifted ground reference SHIFTED_GND, a second conduction terminal coupled to the latching output L_OUT of the first latching unit 10a (and to the top plate of the second coupling capacitor 13b of the same first latching unit 10a), and a gate terminal coupled to the third reset input of the same high-level shifting stage 4, receiving the second high-level shifted input reset signal LS_RESET_N.

The high-level shifting stage 4 further comprises an output inverting buffer 22, having an input coupled to the output of the first NOR logic gate 16b' of the second driving unit 16b (and the bottom plate of the second coupling capacitor 13b of the second latching unit 10b), receiving the biasing signal CP3_BOT, and an output defining the second output of the high-level shifting stage 4 providing the medium-level shifted output voltage MLS_OUT.

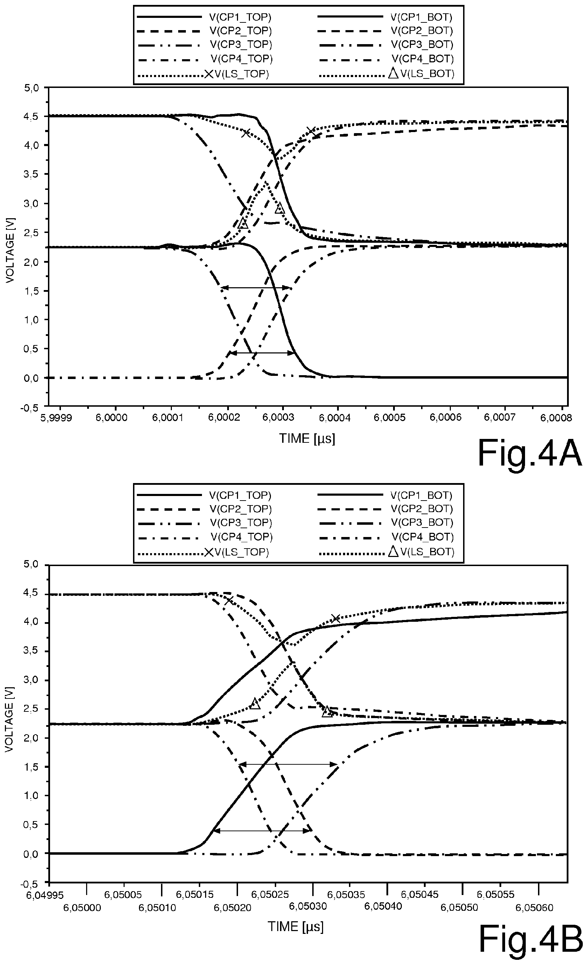

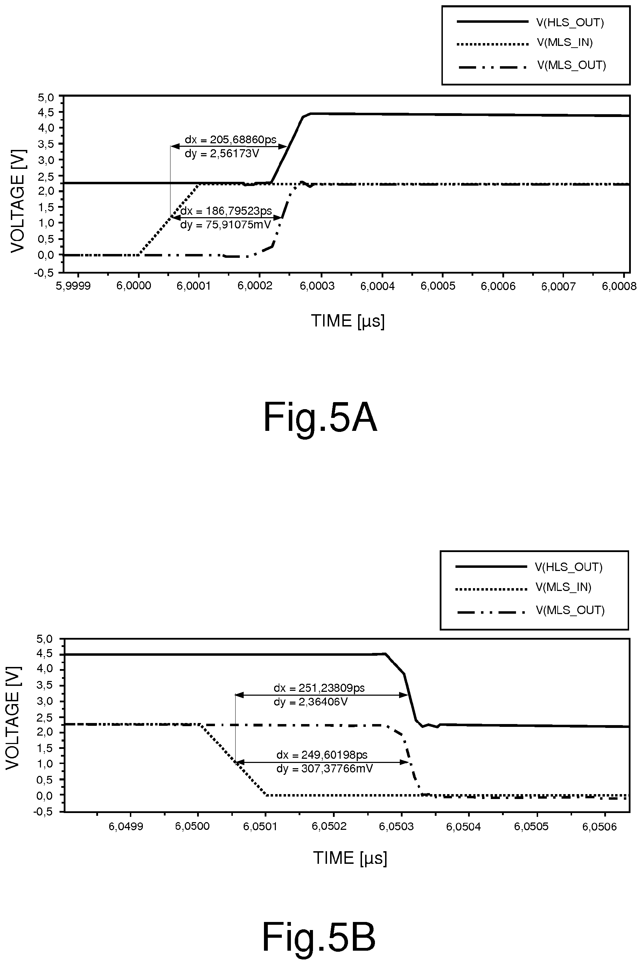

Operation of the high-level shifting stage 4 is now discussed, also referring to the plots of the relevant signals shown in Figure 4A, 4B and Figure 5A, 5B.

In general, operation of the high-level shifting stage 4 is based on inputting the switching transitions of the medium level shifted input voltage MLS_IN into the latching core 10 via capacitive coupling, through the capacitive-coupling units 13, determining shifting of the biasing signals and switching of the latching state.

According to a particular aspect of the present solution, local supply to the first and second latching units 10a, 10b is cut-off during switching, driving in the OFF state both decoupling transistors 14a, 14b and 15a, 15b of the first and second decoupling units 14, 15; in this manner, energy required for switching is greatly reduced and, also, switching speed is greatly increased, since the latching units 10a, 10b are set in the proper switching state when the local supply to the same latching units 10a, 10b is restored, thereby providing a very fast switching of the high-level shifted output voltage HLS_OUT and of the medium-level shifted output voltage MLS_OUT.

According to the above, advantageously, reduced capacitance values and minimum-sized transistors may be used in the level shifter circuit 1, with a great saving in term of area occupation.

In more details, let's suppose that the medium level shifted input voltage MLS_IN switches from the low (GND) to a high value (i.e. equal to the intermediate supply voltage V_{PL}) for a 0 -> 1 switching transition, with the level shifted input reset signal LS_RESET being inactive (in this case, as will be discussed in detail also in the following, being at the high level, i.e. equal to the intermediate supply voltage V_{PL}).

Before switching, the output of the first NAND logic gate 16a' of the first driving unit 16a is in the high state ('1'), while the output of the second NAND logic gate 16a" of the same first driving unit 16a is in the low state ("0").

At the rising edge of the medium level shifted input voltage MLS_IN, the output of the second NAND logic gate 16a" immediately switches to the high state, while the output of the first NAND logic gate 16a' is still in the high state; indeed, switching of the output of the first NAND logic gate 16a' to the low state may occur only after a certain delay, due to propagation delay of the signals from the second NAND logic gate 16a".

Therefore, there is a time interval, during switching, e.g. in the order of 100-150 ps (10⁻¹² s), in which biasing signals CP1_BOT, CP2_BOT are overlapping at the high level (this time interval is shown with the arrow in Figure 4A, relating to the 0 -> 1 switching transition). In particular, the gate terminal of the first decoupling transistor 14a is already high (causing turn-off of the first decoupling transistor 14a), while the gate terminal of the second decoupling transistor 14b is switching in the same high state (thereby causing turn-off also of the second decoupling transistor 14b); accordingly, the top level-shifted line LS_TOP is decoupled or isolated from the line at the high supply voltage V_{PH} (i.e. it is connected to the same high supply voltage V_{PH} via a very high resistance) during switching of the medium level shifted input voltage MLS_IN.

Operation of the second driving unit 16b substantially corresponds to what discussed above for the first driving unit 16a.

In this case, before switching, the output of the second NOR logic gate 16b" of the second driving unit 16b is initially in the low state ('0'), while the output of the first NOR logic gate 16b' is in the high state ('1').

At the rising edge of the medium level shifted input voltage MLS_IN, the output of the first NOR logic gate 16b' immediately switches to the low state, while the output of the second NOR logic gate 16b" is still in the low state; indeed, switching of the output of the second NOR logic gate 16b" to the high state may occur only after a certain delay, due to the propagation of the signals from the first NOR logic gate 16b'.

Therefore, the above discussed time interval occurs, during switching, in which biasing signals CP3_BOT, CP4_BOT are overlapping, in this case, at the low level (this time interval is also shown with the arrow in Figure 4A). In particular, the gate terminal of the second decoupling transistor 15b is already low (causing turn-off of the same second decoupling transistor 15b), while the gate terminal of the first decoupling transistor 15a is switching in the same low state (thereby causing turn-off also of the first decoupling transistor 15a); accordingly, also the bottom level-shifted line LS_BOT is decoupled or isolated from the line at the level-shifted ground reference SHIFTED_GND (i.e. it is connected to the same level-shifted ground reference SHIFTED_GND via a very high resistance) during switching of the medium level shifted input voltage MLS_IN.

As shown in Figure 4A, a drop of the local supply voltage to the latching core 10 therefore occurs (i.e. a drop of the voltage at the top and bottom level-shifted lines LS_TOP, LS_BOT), which facilitates latch switching. The first and second latching units 10a, 10b are isolated from the supply during switching (i.e. they are left floating), providing for a very low energy consumption and a very fast switching of both the high-level shifted output voltage HLS_OUT and the medium-level shifted output voltage MLS_OUT, e.g. in the order of 200-250 ps.

In particular, as shown in Figure 5A (again relating to the 0 -> 1 switching transition), the transitions of the high-level shifted output voltage HLS_OUT and the medium-level shifted output voltage MLS_OUT occur substantially at a same time, with no appreciable delay therebetween. As will be readily appreciated by those skilled in the art, this feature is of great relevance, e.g. to avoid so called cross-conduction or "crossbar" currents between PMOS and NMOS transistors.

As it will be clear based on the previous discussion, and as shown in Figures 5A and 5B, switching of the medium level shifted input voltage MLS_IN from the high to the low value (1 -> 0 switching transition) entails a wholly corresponding operation of the high-level shifting stage 4, again with the latching core 10 being isolated from the supply during commutation, thanks to the biasing signals CP1_BOT, CP2_BOT again overlapping at the high level and the biasing signals CP3_BOT, CP4_BOT again overlapping at the low level.

According to a further aspect of the present solution, the first high-level shifted input reset signal LS_RESET_P and the second high-level shifted input reset signal LS_RESET_N, respectively active at a low level and at a high level, allow to reset, at any time, the state of the first and second latching units 10a, 10b of the latching core 10, in particular by setting the respective latching output L_OUT to the level-shifted ground reference SHIFTED_GND and, respectively, to the high supply voltage V_{PH}.

Moreover, the level shifted input reset signal LS_RESET, at the input of the AND logic gate 18, also sets a reset value for the biasing signals CP1_BOT, CP2_BOT and CP3_BOT, CP4_BOT, independently from the value of the medium level shifted input voltage MLS_IN.

A possible circuit embodiment and the operation of the reset generation stage 6 of the level shifter circuit 1 are now discussed, according to a further aspect of the present solution.

The reset generation stage 6 assures that the first high-level shifted input reset signal LS_RESET_P and the second high-level shifted input reset signal LS_RESET_N are available at any moment during operation of the level shifter circuit 1, and moreover that they are suitably generated with a voltage level that is always referred to proper shifted values, i.e. to the value of the intermediate and high supply voltages V_{PL}, V_{PH} (that may even change during operation, e.g. due to charge pump circuit stages generating the same voltages, as will be clear for a person skilled in the art).

As previously discussed, the first high-level shifted input reset signal LS_RESET_P and the second high-level shifted input reset signal LS_RESET_N are to be generated with values switching between the intermediate and the high supply voltages V_{PL}, V_{PH}.

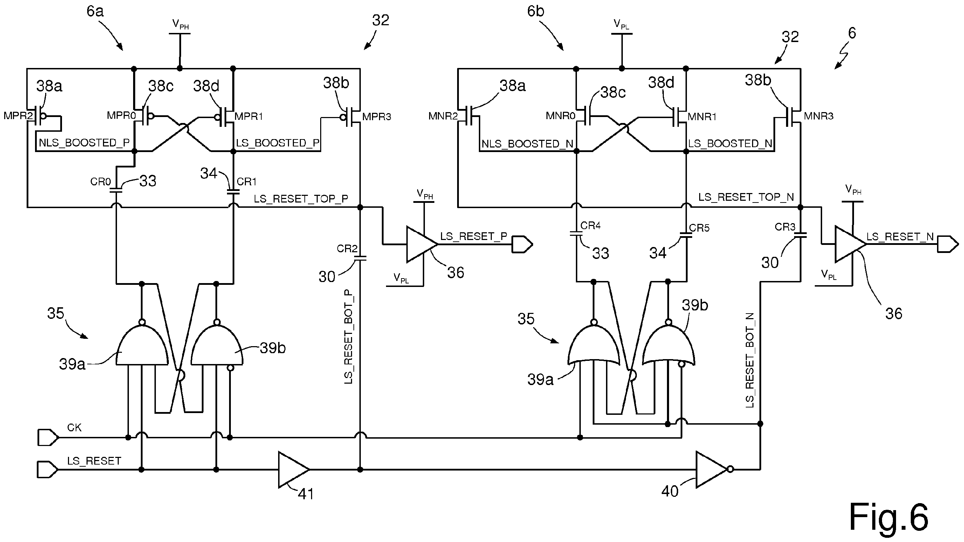

As shown in Figure 6, the reset generation stage 6 comprises a first generation circuit 6a, for generation of the first high-level shifted input reset signal LS_RESET_P, and a second generation circuit 6b, for generation of the second high-level shifted input reset signal LS_RESET_N.

Each of the first and second generation circuits 6a, 6b includes: a respective storing capacitor 30; a refreshing unit 32; a first and a second boosting capacitors 33, 34; a boosting unit 35; and an output buffer 36.

In detail, the refreshing unit 32 has a supply input coupled to the line at the high supply voltage V_{PH}, in case of the first generation circuit 6a, and the intermediate supply voltage V_{PL} in case of the second generation circuit 6b, and comprises refresh transistors of the PMOS type in case of the first generation circuit 6a and of the NMOS type in case of the second generation circuit 6b, and in particular: a first and a second refresh transistors 38a, 38b, coupled between the supply input and a top plate of the storing capacitor 30 (having a voltage denoted as LS_RESET_TOP_P for the first generation circuit 6a and as LS_RESET_TOP_N for the second generation circuit 6b), and having a gate terminal coupled to a top plate of the first, respectively, the second boosting capacitor 33, 34 (having voltages denoted as NLS_BOOSTED_P, LS_BOOSTED_P for the first generation circuit 6a and as NLS_BOOSTED_N, LS_BOOSTED_N for the second generation circuit 6b); and a third and a fourth refresh transistors 38c, 38d, coupled between the supply input and the top plate of the first, respectively, the second boosting capacitor 33, 34, and having a gate terminal coupled to the top plate of the second, respectively the first, boosting capacitor 34, 33.

The boosting unit 35 includes logic gates (NAND logic gates in case of the first generation circuit 6a and NOR logic gates in case of the second generation circuit 6b), and in particular a first logic gate 39a and a second logic gate 39b.

The first logic gate 39a has a first input receiving a timing or clock signal CK, a second input receiving the level shifted input reset signal LS_RESET, in case of the first generation circuit 6a, or a negated version of the same level shifted input reset signal LS_RESET, generated by a suitable inverter 40, in case of the second generation circuit 6b, a third input coupled to an output of the second logic gate 39b, and a respective output coupled to the bottom plate of the first boosting capacitor 33; and a second logic gate 39b, having a first input coupled to the output of the first logic gate 39a, a second input receiving the level shifted input reset signal LS_RESET, in case of the first generation circuit 6a, or a negated version of the same level shifted input reset signal LS_RESET, generated by the inverter 40, in case of the second generation circuit 6b, a third input, negated, receiving the clock signal CK (thus inputting a negated version thereof), and an output coupled to the bottom plate of the second boosting capacitor 34.

The bottom plate of the storing capacitor 30 (having a voltage denoted as LS_RESET_BOT_P for the first generation circuit 6a and as LS_RESET_BOT_N for the second generation circuit 6b) is coupled to the output of a buffer 41, which receives at its input the level shifted input reset signal LS_RESET in case of the first generation circuit 6a; or it is coupled to the output of the inverter 40, in case of the second generation circuit 6b, thus receiving the negated version of the same level shifted input reset signal LS_RESET.

The output buffer 36 is referred between the high power supply V_{PH} and the intermediate power supply V_{PL} and has an input coupled to the top plate of the storing capacitor 30 and an output defining the first reset output of the reset generation stage 6 providing the first high-level shifted input reset signal LS_RESET_P, in case of the first generation circuit 6a, or the second reset output of the same reset generation stage 6 providing the second high-level shifted input reset signal LS_RESET_N, in case of the second generation circuit 6b.

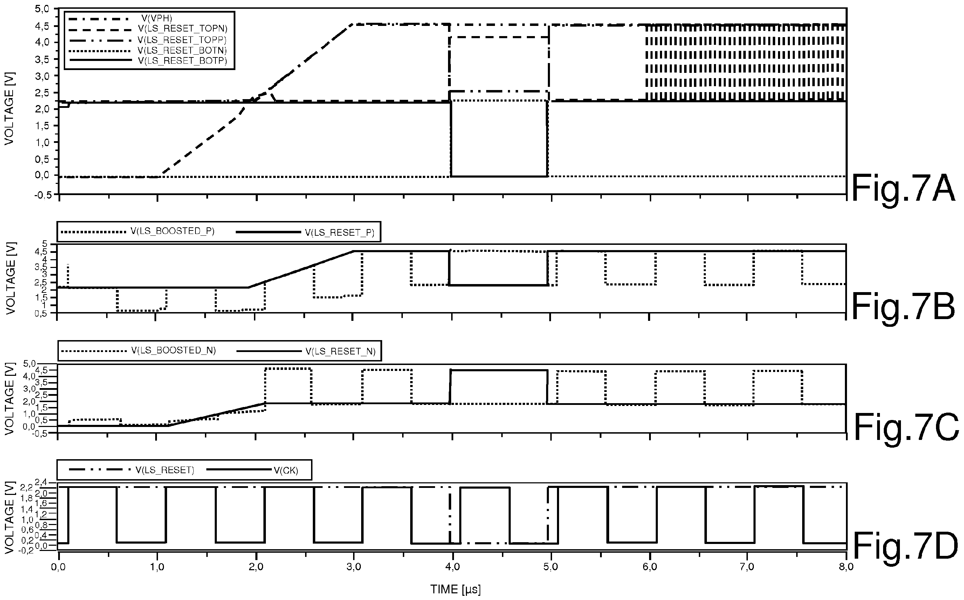

Operation of the reset generation stage 6 is now discussed in more details, also referring to the diagrams of the relevant electrical quantities shown in Figures 7A-7D; in particular, reference is made first to the first generation circuit 6a.

When the level shifted input reset signal LS_RESET is not active (in the discussed embodiment, being at the high level, i.e. equal to the intermediate supply voltage V_{PL}), the combined operation of the boosting unit 35, first and second boosting capacitors 33, 34 and refreshing unit 32 is that of continuously refreshing the voltage value stored in the storing capacitor 30; in particular, the bottom plate of the storing capacitor 30 is at the level of the intermediate supply voltage V_{PL}, while the top plate of the same storing capacitor 30 is at the level of the high supply voltage V_{PH}.

Accordingly, the value of the first high-level shifted input reset signal LS_RESET_P at the output of the output buffer 36 is high, i.e. equal to the high supply voltage V_{PH}; as previously discussed, this value drives in the OFF state the first reset transistor 20a of the high-level shifting stage 4, since no reset is in this case required.

In more details, at each half period of the clock signal CK, either the output of the first logic gate 39a, or the output of the second logic gate 39b is high (while the output of the other logic gate is low), so that either the first or second boosting capacitor 33, 34 provides a boosted voltage at the gate terminals of the first and fourth refresh transistors 38a, 38d, respectively of the second and third refresh transistors 38b, 38c. In particular, when the clock signal CK is at the high level ('1'), the output of the first logic gate 39a is high and the output of the second logic gate 39b is low; whereas, when the clock signal CK is at the low level ('0'), the output of the first logic gate 39a is low and the output of the second logic gate 39b is high.

Accordingly, at each half period of the clock signal CK, the top plate of the storing capacitor 30 is refreshed to the level of the high supply voltage V_{PH}, either by the first and fourth refresh transistors 38a, 38d, or by the second and third refresh transistors 38b, 38c, being in the ON state.

When the reset signal is to be activated, the level shifted input reset signal LS_RESET switches to the low level (in the discussed embodiment, being equal to the ground reference GND), so that the output of both the first and the second logic gates 39a, 39b is brought to the high level. The gate terminals of all refresh transistors 38a, 38b, 38c, 38d is high, and the same refresh transistors are all set in the OFF state, thus stopping refresh of the storing capacitor 30 to the high supply voltage V_{PH}.

Therefore, the top plate of the same storing capacitor 30 undergoes a same voltage drop as the bottom plate, shifting from V_{PH} to V_{PH}-V_{PL}, i.e. to the value of the intermediate supply voltage V_{PL}, since in the discussed embodiment it is assumed that V_{PH}≈2·V_{PL}.

Accordingly, the value of the first high-level shifted input reset signal LS_RESET_P at the output of the output buffer 36 shifts to the low state, i.e. being equal to the intermediate supply voltage V_{PL}; as previously discussed, this value drives in the ON state the first reset transistor 20a of the high-level shifting stage 4, implementing reset of the second latching unit 10b.

It is noted that this reset condition may be maintained as long as the storing capacitor 30 maintains its charge, for example for a time interval in the order of 1 µs (as in the example shown in Figures 7A-7D).

Operation of the second generation circuit 6b corresponds to that of the first generation circuit 6a, so that it is not discussed in details.

In this case, when reset is not active, the bottom plate of the respective storing capacitor 30 is set at the ground reference GND, while the top plate of the same storing capacitor 30 is continuously refreshed at the value of the intermediate supply voltage V_{PL}, that is provided at the supply input of the second generation circuit 6b, through the combined operation of the boosting unit 35, first and second boosting capacitors 33, 34 and refreshing unit 32.

Accordingly, the value of the second high-level shifted input reset signal LS_RESET_N at the output of the respective output buffer 36 is low, i.e. equal to the intermediate supply voltage V_{PL}; as previously discussed, this value drives in the OFF state the second reset transistor 20b of the high-level shifting stage 4, since no reset is in this case required.

When the reset signal is to be activated and the level shifted input reset signal LS_RESET switches to the low level, the bottom plate of the storing capacitor 30 experiences an increase equal to the value of the intermediate supply voltage V_{PL}, while refresh of the top plate thereof is stopped (since the output of both first and second logic gates 39a, 39b is brought to the low level, thus driving all refresh transistors 38a-38d in the OFF state).

Therefore, the top plate of the same storing capacitor 30 undergoes a same voltage increase as the bottom plate, shifting from V_{PL} to V_{PL}+V_{PL}, i.e. to the value of the high supply voltage V_{PH}, since in the discussed embodiment it is assumed that V_{PH}≈2·V_{PL}.

Accordingly, the value of the second high-level shifted input reset signal LS_RESET_N at the output of the output buffer 36 shifts to the high state, i.e. being equal to the high supply voltage V_{PH}; as previously discussed, this value drives in the ON state the second reset transistor 20b of the high-level shifting stage 4, implementing reset of the first latching unit 10a.

As shown in Figures 7A-7C, the value of the first and second high-level shifted reset signals LS_RESET_P LS_RESET_N follows possible variations of the supply voltage (in the example, an increase of the high supply voltage V_{PH} is shown), in a very short time.

Indeed, just a few clock cycles (e.g. less than five clock cycles) are sufficient for the refresh operations performed on the storing capacitor 30 to bring the voltage of the top plate of the same storing capacitor 30 to the new value of the supply voltage (in the example shown, experiencing a corresponding increase as the high supply voltage V_{PH}).

As mentioned previously, the level shifter circuit 1 may find advantageous application in an integrated non-volatile memory device.

As illustrated schematically in Figure 8, a non-volatile memory device, designated by 100, comprises in general a memory array 42 constituted by a plurality of memory cells 43, arranged in wordlines WL and bitlines BL.

Each memory cell 43 is constituted by a storage element, including a phase-change material element (for example, a chalcogenide, such as GST) in the example shown of PCM memories and an access transistor (in the case shown a BJT transistor), appropriately connected to a respective bitline BL and to a respective wordline WL.

A column decoder 44 and a row decoder 45 enable selection of the memory cells 43 on the basis of address signals received at the input (generated in a known way and designated as a whole by AS) and appropriate decoding schemes, and in particular selection of the corresponding bitlines BL and of the corresponding wordlines WL, each time addressed, enabling their biasing at desired voltage and current values during the reading and programming operations, by means of appropriate driving stages.

Moreover, a reading stage is selectively coupled to the memory array 42 via the column decoder 44, during the operations of reading of the contents of the memory cells 43.

The level shifter circuit 1 according to the present solution may, for example, be used within the column and row decoders 44, 45 to enable generation of the appropriate quantities, for selection and biasing of the bitlines BL and wordlines WL.

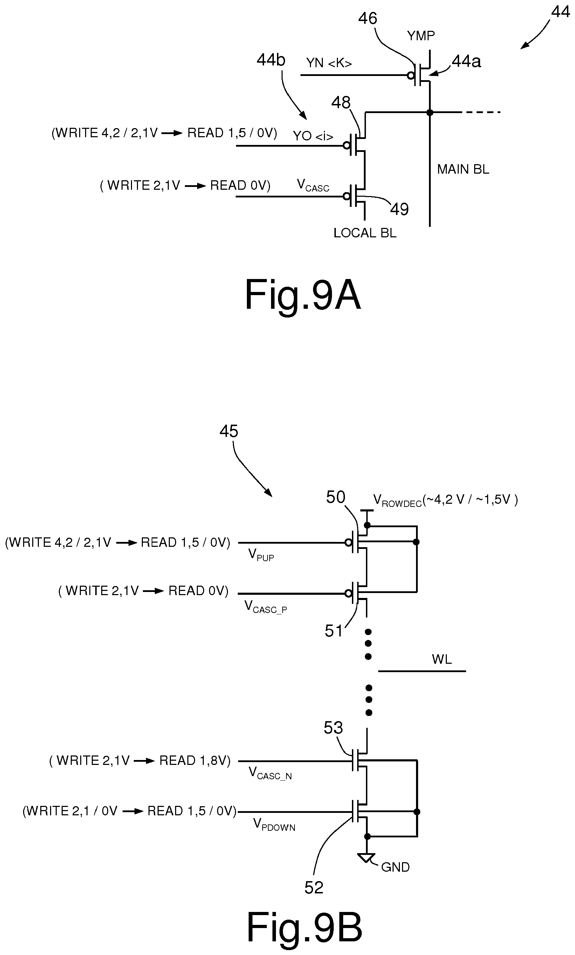

In particular, as schematically shown in in Figure 9A, the column decoder 44 may have, in a per se known manner, a hierarchical decoding structure, with a number of decoding stages.

A first decoding stage 44a includes a plurality of global-selection transistors 46 (only one of which is shown in the schematic depiction of Figure 9A), in the example of a PMOS type, which enable selection and biasing of a respective global bitline (or main bitline) MBL, for a respective sector of the memory array 42 (here not shown).

Each global-selection transistor 46 receives on a control terminal thereof a respective global-selection signal YN<k>, having a first value, for example a low value, for connecting the respective global bitline MBL to a respective module (driver) of the driving stage of the non-volatile memory device 100, which supplies a driving signal YMP, and a second value, in the example high, for disconnecting the same global bitline MBL from the driving stage.

A second decoding stage 44b includes a plurality of local-selection transistors 48 (again, only one of which is shown in Figure 9A), in the example of a PMOS type, for each sector of the memory array 42, each connected between a respective global bitline MBL and a respective local bit line BL to which memory cells 43 are connected (not illustrated herein).

Each local-selection transistor 48 receives on a control terminal thereof a respective local-selection signal YO<i>, which has a first value, for example low, for connecting the global bitline MBL associated to the respective sector to a respective local bitline BL (and to the associated memory cells 43), and a second value, in the example high, for disconnecting the same global bitline MBL from the respective bitline BL.

Moreover, a cascode transistor 49 is coupled between the local bitline BL and each local-selection transistor 48, having a control terminal receiving a cascode voltage V_{CASC}, with a value suitable to avoid over-voltages across the decoder transistor terminals (for example, transistors may be sized so that a maximum voltage allowed between their terminals is equal to 1.8 V).

The global-selection signal YN<k> and the local-selection signal YO<i> are referred to shifted voltage values, e.g. equal to 4.2V or 2.1V depending on the memory operation being performed and may be generated by a respective level shifter circuit 1 (as the one previously disclosed in details). Also the cascode voltage V_{CASC} is required to have suitable shifted voltages, e.g. equal to 2.1 V and may be also generated by level shifter circuit 1.

Advantageously, the two parallel shifting paths present in the level shifter circuit 1 may be exploited to generate the intermediate supply voltage V_{PL}, in this case corresponding to the cascode voltage V_{CASC}; and the high supply voltage V_{PH}, in this case corresponding to the global-selection signal YN<k> and local-selection signal YO<i>.

The presence of level shifter circuits 1 is also required in the row decoders 45.

In particular, as schematically shown in in Figure 9B, the row decoder 45 may envisage that word lines WL are normally biased to a positive voltage in an unselected status, and grounded when selected.

Accordingly, for each word line WL, the row decoder 44 may include a pull-up transistor 50, of a PMOS type, controllable to couple the word line WL to a row decoder supply voltage V_{ROWDEC} (e.g. equal to 4.2V for writing operations or 1,5V for reading operations); a first cascode transistor 51, also of a PMOS type, may again be coupled between the word line WL and the respective pull-up transistor 50, for overvoltage protection, receiving a first cascode voltage V_{CASCP} at the control terminal.

The control terminal of the a pull-up transistor 50 may require e.g. voltages V_{PUP} equal to 4.2V or 2.1V during writing and 1.5V or 0V during reading operations; while the first cascode voltage V_{CASCP} provided to the control terminal of the first cascode transistor 51 may be equal to 2,1V or 0V during writing or, respectively, reading operations.

Likewise, the row decoder 45 may include a pull-down transistor 52, of a NMOS type, controllable to couple the word line WL to a ground reference GND; a second cascode transistor 53, also of a NMOS type, may again be coupled between the word line WL and the respective pull-down transistor 52, for overvoltage protection, receiving a second cascode voltage V_{CASCN} at the control terminal.

The control terminal of the pull-down transistor 52 may require e.g. voltages V_{PDOWN} equal to 2.1V or 0V during writing and 1.5V or 0V during reading operations; while the second cascode voltage V_{CASCN} provided to the control terminal of the second cascode transistor 53 may be equal to 2.1V or 1.8V during writing or, respectively, reading operations.

Advantageously, the two parallel shifting paths present in the level shifter circuit 1 may in this case be exploited to generate the first and second cascode voltages V_{CASCP}, V_{CASCN}, required for the above discussed different voltage domains. In particular, simultaneous switching transitions obtained for the first and second cascode voltages V_{CASCP}, V_{CASCN} allow to avoid crossbar currents between supply and ground reference in the row decoder 45.

The advantages of the solution proposed are clear from the foregoing description.

In any case, it is again underlined that it allows to achieve fast level transitions, low power consumption and small area occupation.

Moreover, in the proposed solution, level shifting operations in the medium-voltage and high-voltage domains are performed in parallel, with minimum delays between the level transitions, so as to avoid current cross-conductions, e.g. through NMOS and PMOS transistors.

The level shifter circuit 1 also provides a dedicated reset scheme for initialization, with properly level-shifted reset signals, which are also able to adapt to the supply voltage values that are applied.

The proposed solution is therefore particularly advantageous in particularly scaled technologies (for example, the 28-nm FD-SOI technology), and, in general, for applications in non-volatile memory devices, for example in corresponding column and/or row decoders.

Finally, it is clear that modifications and variations may be made to what has been described and illustrated herein, without thereby departing from the scope of the present invention, as defined in the annexed claims.

In particular, it is underlined that, even though particular reference has been made to the use of the level shifter circuit within non-volatile memory devices, the solution described may be advantageously employed in any application in which level shifting of an input signal into an output signal with fast transitions, low circuit complexity and low power consumption is required.

## Claims

1. A level shifter circuit (1), configured to shift an input signal (LV_IN), switching within a first voltage range, to generate at least a first output signal (HV_OUT), correspondingly switching within a second voltage range, higher than the first voltage range, comprising:
a latching core (10) having latching input and output terminals (L_IN, L_OUT) and having a supply line (LS_TOP) designed to be supplied by a supply voltage (V_{PH}) and a reference line (LS_BOT) designed to be coupled to a reference voltage (SHIFTED_GND);
capacitive-coupling elements (13a-13b) coupled to the latching input and output terminals of the latching core (10) ;
a driving stage (16) configured to bias the capacitive-coupling elements (13a-13b) with biasing signals (CP1_BOT-CP4_BOT) generated based on the input signal, said capacitive-coupling elements (13a-13b) capacitively coupling the latching input terminal (L_IN) and the latching output terminal (L_OUT) to output lines of the driving stage (16) carrying the biasing signals (CP1_BOT-CP4_BOT); and
a decoupling stage (14, 15) configured to decouple the supply line (LS_TOP) from the supply voltage (V_{PH}) and the reference line (LS_BOT) from the reference voltage (SHIFTED_GND) during switching of the input signal,
**characterized in that** the decoupling stage (14, 15), is driven by the driving stage (16) through the capacitive-coupling elements (13a-13b), to decouple the supply line (LS_TOP) from the supply voltage (V_{PH}) and the reference line (LS_BOT) from the reference voltage (SHIFTED_GND) during switching of the input signal.

2. The level shifter circuit according to claim 1, further configured to generate a second output signal (MV_OUT), correspondingly switching within a third voltage range, intermediate between the first voltage range and the second voltage range; wherein the first and the second output signals (HV_OUT; MV_OUT) have corresponding and concurrent switching transitions.

3. The level shifter circuit according to claim 1 or 2, wherein the decoupling stage comprises a first decoupling unit (14), including a couple of decoupling PMOS transistors (14a, 14b) connected between the supply line (LS_TOP) and a line at the supply voltage (V_{PH}) and having control terminals driven by the driving stage (16) through the capacitive-coupling elements (13a-13b), and a second decoupling unit (15) including a couple of decoupling NMOS transistors (15a, 15b) connected between the reference line (LS_BOT) and a line at the reference voltage (SHIFTED_GND) and having respective control terminals driven by the driving stage (16) through the capacitive-coupling elements (13a-13b); wherein the driving stage (16) is configured to generate a first and a second biasing signals (CP1_BOT, CP2_BOT) with overlapping positive values during switching of the input signal, to drive the control terminals of the couple of decoupling PMOS transistors (14a, 14b) through respective capacitive-coupling elements (13a-13b), and a third and a fourth biasing signals (CP3_BOT, CP4_BOT) with overlapping negative values during switching of the input signal, to drive the control terminals of the couple of decoupling NMOS transistors (15a, 15b) through respective capacitive-coupling elements (13a-13b).

4. The level shifter circuit according to claim 3, wherein the driving stage (16) comprises a first and a second driving units (16a, 16b), of a NAND and, respectively, NOR logic type, each including a first (16a', 16b') and a second (16a", 16b") logic gates, configured to provide at the output the biasing signals (CP1_BOT-CP4_BOT); wherein the first and second driving units (16a, 16b) are configured to generate the first and second biasing signals (CP1_BOT, CP2_BOT), respectively the third and a fourth biasing signals (CP3_BOT, CP4_BOT), having opposite values, except for an overlapping interval during switching of the input signal, during which the first and second biasing signals (CP1_BOT, CP2_BOT) have the overlapping positive values and the third and fourth biasing signals (CP3_BOT, CP4_BOT) have the overlapping negative values; the overlapping period being a function of a logic-gate propagation delay between the first (16a', 16b') and the second (16a", 16b") logic gates.

5. The level shifter circuit according to claim 4, wherein the first logic gate (16a', 16b') has a first input receiving a biasing input (P_IN) being a function of the input signal (LV_IN), a second input coupled to the output of the second logic gate (16a", 16b") and an output providing a respective biasing signal (CP1_BOT, CP3_BOT); and the second logic gate (16a", 16b") has a respective first input receiving the negated biasing input, a respective second input coupled to the output of the first logic gate (16a', 16b') and a respective output providing a respective biasing signal (CP2_BOT, CP4_BOT).

6. The level shifter circuit according to any of claims 3-5, wherein the latching core (10) includes a first latching unit (10a) and a second latching unit (10b), each having a latching input (L_IN) and a latching output (L_OUT); wherein the latching input and output of the first latching unit (10a) are coupled to a top plate of a first (C1), respectively, second (C2) capacitive-coupling element (13a, 13b) and to the control terminals of the decoupling PMOS transistors (14a, 14b), and the latching input and output of the second latching unit (10b) are coupled to a top plate of a respective third (C4), respectively, fourth (C3) capacitive-coupling element (13a, 13b) and to the control terminals of the decoupling NMOS transistors (15a, 15b); and wherein bottom plates of the first and second capacitive-coupling elements associated to the first latching unit (10a) are coupled to the driving stage (16) to receive the first and second biasing signals (CP1_BOT, CP2_BOT), and bottom plates of the third and fourth capacitive-coupling elements associated to the second latching unit (10b) are coupled to the driving stage (16) to receive the third and fourth biasing signals (CP3_BOT, CP4_BOT).

7. The level shifter circuit according to claim 6, comprising a first output configured to provide a high-level shifted output signal (HLS_OUT) for generation of the first output signal (HV_OUT), and coupled to the top plate of the fourth capacitive-coupling element (13b) associated to the latching output (L_OUT) of the second latching unit (10b) via an inverting stage (19) referred to the supply voltage (V_{PH}) and the reference voltage (SHIFTED_GND); and a second output configured to provide a medium-level shifted output signal (MLS_OUT) for generation of a second output signal (MV_OUT), switching within a third voltage range, intermediate between the first and the second voltage range, coupled to the bottom plate of said fourth capacitive-coupling element (13b) associated to the latching output (L_OUT) of the second latching unit (10b) via an inverting buffer (22); wherein the first and the second output signals (MV_OUT, HV_OUT) have corresponding and concurrent switching transitions.

8. The level shifter circuit according to any of the preceding claims, further comprising: a reset generation stage (6) configured to generate a first and a second level-shifted reset signals (LS_RESET_P, LS_RESET_N) at a first and a second reset output, to initialize the latching core (10) based on an input reset signal (LS_RESET) and a timing signal (CK); a first reset transistor (20a), of the PMOS type, coupled between the supply line (LS_TOP) and a first latching output terminal (L_OUT) of the latching core (10) and having a control terminal receiving the first level-shifted reset signal (LS_RESET_P); and a second reset transistor (20b), of the NMOS type, coupled between the reference line (LS_BOT) and a second latching output terminal (L_OUT) of the latching core (10) and having a control terminal receiving the second level-shifted reset signal (LS_RESET_N).

9. The level shifter circuit according to claim 8, wherein the reset generation stage (6) comprises a first generation circuit (6a), for generation of the first level-shifted reset signal (LS_RESET_P), and a second generation circuit (6b), for generation of the second level-shifted reset signal (LS_RESET_N) ; wherein each of the first and second generation circuits (6a, 6b) includes: a respective storing capacitor (30), having a bottom plate receiving the input reset signal (LS_RESET), in case of the first generation circuit (6a), respectively the negated input reset signal, in case of the second generation circuit (6b), and a top plate coupled to the first, respectively, second reset output via a respective output buffer (36) having a first supply input receiving the supply voltage (V_{PH}) and a second supply input receiving an intermediate voltage (V_{PL}), lower than the supply voltage (V_{PH}) ; a refreshing unit (32) supplied by the supply voltage (V_{PH}), in case of the first generation circuit (6a), respectively the intermediate voltage (V_{PL}) in case of the second generation circuit (6b), and configured to refresh a voltage of the top plate of the storing capacitor (30) to the value of the supply voltage (V_{PH}), respectively to the value of the intermediate voltage (V_{PL}), continuously at each cycle of the clock signal (CK) if the reset signal (LS_RESET) is in an inactive state, and to stop refreshing the storing capacitor (30) if the reset signal (LS_RESET) switches to the active state.

10. The level shifter circuit according to claim 9, wherein the refreshing unit (32) includes at least a first (38a) and a second (38b) refresh transistors, in case of the first generation circuit (6a) being of the PMOS type and coupled between the supply voltage (V_{PH}) and the top plate of the respective storing capacitor (30), and in case of the second generation circuit (6b) being of the NMOS type and coupled between the intermediate voltage (V_{PL}) and the top plate of the respective storing capacitor (30); and wherein each of the first and second generation circuits (6a, 6b) further includes: a first and a second boosting capacitors (33, 34), having a top plate coupled to the control terminal of the first (38a), respectively the second (38b) refresh transistors; and a boosting unit (35), coupled to a bottom plate of the first and second boosting capacitors (33, 34), configured to drive said bottom plate with opposite-level boosting signals at each cycle of the timing signal (CK) if the input reset signal (LS_RESET) is in an inactive state, and with boosting signals of a same level, such as to turn-off both first and second refresh transistors (38a, 38b), upon the input reset signal (LS_RESET) switching to the active state.

11. The level shifter circuit according to claim 10, wherein the boosting unit (35) is of a NAND logic type in case of the first generation circuit (6a), respectively of the NOR logic type in case of the second generation circuit (6b), and includes a first (39a) and a second (39b) logic gates, configured to provide at the output the boosting signals; wherein the first logic gate (39a) has a first input receiving the timing signal (CK), a second input receiving the input reset signal (LS_RESET) in case of the first generation circuit (6a), respectively the negated input reset signal in case of the second generation circuit (6b), a third input coupled to the output of the second logic gate (39b) and an output providing a respective boosting signal; and the second logic gate (39b) has a respective first input receiving the negated timing signal, a second input receiving the input reset signal (LS_RESET) in case of the first generation circuit (6a), respectively the negated input reset signal in case of the second generation circuit (6b), a third input coupled to the output of the first logic gate (39a) and an output providing a respective boosting signal.

12. A decoder stage (44, 45) for a memory device (100), having a memory array (42) including a plurality of memory cells (43) arranged in wordlines (WL) and bitlines (BL), the decoder stage (44, 45) configured to select and bias the wordlines (WL) and/or bitlines (BL) as a function of address signals (AS); wherein said decoder stage (44, 45) comprises a plurality of shifter modules, each including at least a level shifter circuit (1) according to any one of the preceding claims.

13. The decoder stage according to claim 12, comprising a plurality of selection transistors (46, 48, 50, 52), which are operable for selecting said wordlines (WL) and/or said bitlines (BL) for memory operations, and cascode transistors (49, 51, 53), coupled to the selection transistors; wherein the level shifter circuits (1) are configured to generate a respective control signal (YN, YO, V_{PUP}, V_{PDOWN}) for the control terminals of said selection transistors and/or a respective cascode voltage (V_{CASC}, V_{CASCN}, V_{CASCP}) for the gate terminals of said cascode transistors.

14. A memory device (100), including a memory array (42) with wordlines (WL) and bitlines (BL) and a decoder stage (44, 45) according to claim 12 or 13, to select the wordlines and bitlines according to address signals (AS).

15. The memory device according to claim 14, being of a PCM type.

## Patentansprüche

1. Pegelschieberschaltung (1), konfiguriert, um ein Eingangssignal (LV_IN), das innerhalb eines ersten Spannungsbereichs schaltet, zu schieben, um mindestens ein erstes Ausganssignal (HV_OUT) zu generieren, das entsprechend innerhalb eines zweiten Spannungsbereichs schaltet, der höher als der erste Spannungsbereich ist, umfassend:
einen Verriegelungskern (10), der Verriegelungseingangs- und Ausgangsanschlüsse (L_IN, L_OUT) aufweist und eine Versorgungsleitung (LS_TOP) aufweist, die gestaltet ist, um mit einer Versorgungsspannung (V_{PH}) versorgt zu werden, und eine Referenzleitung (LS_BOT), die gestaltet ist, um an eine Referenzspannung (SHIFTED_GND) gekoppelt zu werden; kapazitive Kopplungselemente (13a-13b), die an die Verriegelungseingangs- und Ausgangsanschlüsse des Verriegelungskerns (10) gekoppelt sind,
eine Treiberstufe (16), konfiguriert, um die kapazitiven Kopplungselemente (13a-13b) mit Beeinflussungssignalen (CP1_BOT_CP4_BOT) zu beeinflussen, die basierend auf dem Eingangssignal generiert werden, wobei die kapazitiven Kopplungselemente (13a-13b) den Verriegelungseingangsanschluss (L_IN) und den Verriegelungsausgangsanschluss (L_OUT) an Ausgangsleitungen der Treiberstufe (16) koppeln, die die Beeinflussungssignale (CP1_BOT_CP4_BOT) tragen; und
eine Entkopplungsstufe (14, 15), konfiguriert zum Entkoppeln der Versorgungsleitung (LS_TOP) von der Versorgungsspannung (V_{PH}) und der Referenzleitung (LS_BOT) von der Referenzspannung (SHIFTED_GND) während des Schaltens des Eingangssignals,
**dadurch gekennzeichnet, dass** die Entkopplungsstufe (14, 15) durch die Treiberstufe (16) durch die kapazitiven Kopplungselemente (13a-13b) angesteuert wird, um die Versorgungsleitung (LS_TOP) von der Versorgungsspannung (V_{PH}) und der Referenzleitung (LS_BOT) von der Referenzspannung (SHIFTED_GND) während des Schaltens des Eingangssignals zu entkoppeln.

2. Pegelschieberschaltung nach Anspruch 1, weiter konfiguriert zum Generieren eines zweiten Ausgangssignals (MV_OUT), das entsprechend innerhalb eines dritten Spannungsbereichs, zwischen dem ersten Spannungsbereich und dem zweiten Spannungsbereich zwischenliegend, schaltet; wobei das erste und zweite Ausgangssignal (HV_OUT; MV_OOUT) entsprechende und gleichlaufende Schaltübergänge aufweisen.

3. Pegelschieberschaltung nach Anspruch 1 oder 2, wobei die Entkopplungsstufe eine erste Entkopplungseinheit (14) umfasst, die ein Paar von Entkopplungs-PMOS-Transistoren (14a, 14b) beinhalten, die zwischen der Versorgungsleitung (LS_TOP) und einer Leitung an der Versorgungsspannung (V_{PH}) angeschlossen sind, und Steuerungsanschlüsse aufweisen, die von der Treiberstufe (16) durch die kapazitiven Kopplungselemente (13a-13b) angesteuert werden, und eine zweite Entkopplungseinheit (15), die ein Paar von Entkopplungs-NMOS-Transistoren (15a, 15b) beinhalten, die zwischen der Referenzleitung (LS_BOT) und einer Leitung an der Referenzspannung (SHIFTED_GND) angeschlossen sind, und jeweilige Steuerungsanschlüsse aufweisen, die von der Treiberstufe (16) durch die kapazitiven Kopplungselemente (13a-13b) angesteuert werden; wobei die Treiberstufe (16) konfiguriert ist, um ein erstes und zweites Beeinflussungssignal (CP1_BOT, CP2_BOT) mit überlappenden positiven Werten während des Schaltens des Eingangssignals zu generieren, um die Steuerungsanschlüsse des Paares von Entkopplungs-PMOS-Transistoren (14a, 14b) durch jeweilige kapazitive Kopplungselemente (13a-13b) anzusteuern, und ein drittes und ein viertes Beeinflussungssignal (CP3_BOT, CP4_BOT) mit überlappenden negativen Werten während des Schaltens des Eingangssignals zu generieren, um die Steuerungsanschlüsse des Paares von Entkopplungs-NMOS-Transistoren (15a, 15b)durch jeweilige kapazitive Kopplungselemente (13a-13b) anzusteuern.

4. Pegelschieberschaltung nach Anspruch 3, wobei die Treiberstufe (16) eine erste und eine zweite Treibereinheit (16a, 16b), jeweils von einem logischen NAND- und NOR-Typ ist, wobei jede ein erstes (16a', 16b') und ein zweites (16a", 16b") logisches Gate beinhaltet, konfiguriert, um an dem Ausgang Beeinflussungssignale (CP1_BOT-CP4_BOT) bereitzustellen; wobei die erste und zweite Treibereinheit (16a, 16b) konfiguriert sind, um das erste und zweite Beeinflussungssignal (CP1_BOT, CP2_BOT), jeweils das dritte und ein viertes Beeinflussungssignal (CP3_BOT, CP4_BOT) zu generieren, die entgegengesetzte Werte aufweisen, mit Ausnahme für ein überlappendes Intervall während des Schaltens des Eingangssignals, bei dem das erste und zweite Beeinflussungssignal (CP1_BOT, CP2_BOT) die überlappenden positiven Werte aufweisen, und das dritte und vierte Beeinflussungssignal (CP3_BOT, CP4_BOT) die überlappenden negativen Werte aufweisen; wobei die überlappende Zeitspanne von einer Ausbreitungsverzögerung eines logischen Gates zwischen dem ersten erstes (16a', 16b') und zweiten (16a", 16b") logischen Gate ist.

5. Pegelschieberschaltung nach Anspruch 4, wobei das erste logische Gate (16a', 16b') einen ersten Eingang aufweist, der einen Beeinflussungseingang (P_IN) empfängt, der von dem Eingangssignal (LV_IN) abhängig ist, einen zweiten Eingang, der an den Ausgang des zweiten logischen Gates (16a", 16b") gekoppelt ist, und einen Ausgang, der ein jeweiliges Beeinflussungssignal (CP1_BOT, CP3_BOT) bereitstellt; und das zweite logische Gate (16a", 16b") einen jeweiligen ersten Eingang aufweist, der den negierten Beeinflussungseingang empfängt, einen jeweiligen zweiten Eingang, der an den Ausgang des ersten logischen Gates (16a', 16b') gekoppelt ist, und einen jeweiligen Ausgang, der ein jeweiliges Beeinflussungssignal (CP2_BOT, CP4_BOT) bereitstellt.

6. Pegelschieberschaltung nach einem der Ansprüche 3 bis 5, wobei der Verriegelungskern (10) eine erste Verriegelungseinheit (10a) und eine zweite Verriegelungseinheit (10b) beinhaltet, wobei jede einen Verriegelungseingang (L_IN) und einen Verriegelungsausgang (L_OUT) aufweist; wobei der Verriegelungseingang und - ausgang der ersten Verriegelungseinheit (10a) an eine obere Platte jeweils eines ersten (C1), zweiten (C2) kapazitiven Kopplungselements (13a, 13b) und an die Steuerungsanschlüsse der Entkopplungs-PMOS-Transistoren (14a, 14b) gekoppelt ist, und der Verriegelungseingang und -ausgang der zweiten Verriegelungseinheit (10b) an einer obere Platte eines jeweiligen dritten (C4) bzw. vierten (C3) kapazitiven Kopplungselements (13a, 13b) und an die Steuerungsanschlüsse der Entkopplungs-NMOS-Transistoren (15a, 15b) gekoppelt ist; und wobei untere Platten des ersten und zweiten kapazitiven Kopplungselements, die der ersten Verriegelungseinheit (10a) zugeordnet sind, an die Treiberstufe (16) gekoppelt sind, um das erste und zweite Beeinflussungssignal (CP1_BOT, CP2_BOT) zu empfangen, und untere Platten des dritten und vierten kapazitiven Kopplungselements, die der zweiten Verriegelungseinheit (10b) zugeordnet sind, an die Treiberstufe (16) gekoppelt sind, um das dritte und vierte Beeinflussungssignal (CP3_BOT, CP4_BOT) zu empfangen.

7. Pegelschieberschaltung nach Anspruch 6, umfassend einen ersten Ausgang, konfiguriert, um ein verschobenes Ausgangssignal (HLS_OUT) auf hoher Stufe zum Generieren des ersten Ausgangssignals (HV_OUT) bereitzustellen, und der an die obere Platte des vierten kapazitiven Kopplungselements (13b), das dem Verriegelungsausgang (L_OUT) der zweiten Verriegelungseinheit (10b) über eine Umkehrstufe (19), bezogen auf die Versorgungsspannung (V_{PH}) und die Referenzspannung (SHIFTED-GND) zugeordnet ist; und einen zweiten Ausgang, konfiguriert, um ein verschobenes Ausgangssignal (MLS_OUT) auf mittlerer Stufe zum Generieren eines zweiten Ausgangssignals (MV_OUT) bereitzustellen, das innerhalb eines dritten Spannungsbereichs, zwischen dem ersten Spannungsbereich und dem zweiten Spannungsbereich zwischenliegend, schaltet, an die untere Platte des vierten kapazitiven Kopplungselements (13b) gekoppelt, das dem Verriegelungsausgang (L_OUT) der zweiten Verriegelungseinheit (10b) über einen Umkehrpuffer (22), zugeordnet ist; wobei das erste und zweite Ausgangssignal (MV_OUT, HV_OUT) entsprechende und gleichlaufende Schaltübergänge aufweisen.

8. Pegelschieberschaltung nach einem der vorstehenden Ansprüche, weiter umfassend: eine Reset-Generierungsstufe (6), konfiguriert, um ein erstes und ein zweites stufenverschobenes Reset-Signal (LS_RESET_P, LS_RESET_N) an einem ersten und einem zweiten Reset-Ausgang zu generieren, um den Verriegelungskern (10) basierend auf einem Eingangsreset-Signal (LS_RESET) und einem Timing-Signal (CK)zu initialisieren; einen ersten Reset-Transistor (20a), vom PMOS-Typ, der zwischen der Versorgungsleitung (LS_TOP) und einem ersten Verriegelungsausgangsanschluss (L_OUT) des Verriegelungskerns (10) gekoppelt ist, und einen Steuerungsanschluss aufweist, der das erste stufenverschobene Reset-Signal (LS_RESET_P) empfängt; einen zweiten Reset-Transistor (20b), vom NMOS-Typ, der zwischen der Referenzleitung (LS_BOT) und einem zweiten Verriegelungsausgangsanschluss (L_OUT) des Verriegelungskerns (10) gekoppelt ist, und einen Steuerungsanschluss aufweist, der das zweite stufenverschobene Reset-Signal (LS_RESET_N) empfängt.

9. Pegelschieberschaltung nach Anspruch 8, wobei die Reset-Generierungsstufe (6) eine erste Generierungsschaltung (6a) zum Generieren des ersten stufenverschobenen Reset-Signals (LS_RESET_P) umfasst, und eine zweite Generierungsschaltung (6b) zum Generieren des zweiten stufenverschobenen Reset-Signals (LS_RESET_N); wobei jede der ersten und zweiten Generierungsschaltung (6a, 6b) beinhaltet: einen jeweiligen Speicherkondensator (30), der eine untere Platte aufweist, die das Eingangsreset-Signal (LS_RESET) empfängt, im Falle der ersten Generierungsschaltung (6a), bzw. das negierte Eingangsreset-Signal, im Falle der zweiten Generierungsschaltung (6b), und eine obere Platte, die an den ersten bzw. zweiten Reset-Ausgang über einen jeweiligen Ausgangspuffer (36) gekoppelt ist, der einen ersten Versorgungseingang aufweist, der die Versorgungsspannung (V_{PH}) empfängt, und einen zweiten Versorgungseingang, der eine Zwischenspannung (V_{PL}) empfängt, die niedriger als die Versorgungsspannung (V_{PH}) ist; eine Auffrischungseinheit (32), die von der Versorgungsspannung (V_{PH}) versorgt wird, im Fall der ersten Generierungsschaltung (6a), bzw. der Zwischenspannung (V_{PL}) im Falle der zweiten Generierungseinheit (6b), und konfiguriert, um eine Spannung der oberen Platte des Speicherkondensators (30) auf den Wert der Versorgungsspannung (V_{PH}), bzw. auf den Wert der Zwischenspannung (V_{PL}) aufzufrischen, ununterbrochen bei jedem Zyklus des Taktsignals (CK), falls das Reset-Signal (LS_RESET) in einem inaktiven Zustand ist, und das Auffrischen des Speicherkondensators (30) zu stoppen, falls das Reset-Signal (LS_RESET) in den aktiven Zustand schaltet.

10. Pegelschieberschaltung nach Anspruch 9, wobei die Auffrischungseinheit (32) mindestens einen ersten (38a) und einen zweiten (38b) Auffrischungstransistor beinhaltet, in dem Fall, dass die erste Generierungsschaltung (6a) vom PMOS-Typ ist, und zwischen die Versorgungsspannung (V_{PH}) und die obere Platte des jeweiligen Speicherkondensators (30) gekoppelt ist, und im Fall, dass die zweite Generierungsschaltung (6b) vom NMOS-Typ ist, und zwischen die Zwischenspannung (V_{PL}) und die obere Platte des jeweiligen Speicherkondensators (30) gekoppelt ist; und wobei jede der ersten und zweiten Generierungsschaltung (6a, 6b) weiter beinhaltet: einen ersten und einen zweiten Boost-Kondensator (33, 34), die eine obere Platte aufweisen, die an den Steuerungsanschluss des ersten (38a) bzw. des zweiten (38b) Auffrischungstransistors gekoppelt ist; und eine Boost-Einheit (35), die an eine untere Platte des ersten und zweiten Boost-Kondensators (33, 34) gekoppelt ist, konfiguriert, um die untere Platte mit Boost-Signalen entgegengesetzter Stufe bei jedem Zyklus des Timing-Signals (CK) anzusteuern, falls das Eingangsreset-Signal (LS_RESET) in einem inaktiven Zustand ist, und mit Boost-Signalen einer selben Stufe, um beide, den ersten und den zweiten Auffrischungstransistor (38a, 38b) auszuschalten, sobald das Eingangsreset-Signal (LS_RESET) in den aktiven Zustand schaltet.

11. Pegelschieberschaltung nach Anspruch 10, wobei die Boost-Einheit (35) vom logischen NAND-Typ im Falle der ersten Generierungsschaltung (6a), bzw. vom logischen NOR-Typ im Fall der zweiten Generierungsschaltung (6b) ist, und ein erstes (39a) und ein zweites (39b) logisches Gate beinhaltet, die konfiguriert sind, um am Ausgang die Boost-Signale bereitzustellen; wobei das erste logische Gate (39a) einen ersten Eingang aufweist, der das Timing-Signal (CK) empfängt, einen zweiten Eingang, der das Reset-Signal (LS_RESET) empfängt, im Falle der ersten Generierungsschaltung (6a), bzw. das negierte Eingangsreset-Signal im Falle der zweiten Generierungsschaltung (6b), einen dritten Eingang, der an den Ausgang des zweiten logischen Gates (39b) gekoppelt ist, und einen Ausgang, der ein jeweiliges Boost-Signal bereitstellt; und das zweite logische Gate (39b) einen jeweiligen ersten Eingang aufweist, der das negierte Timing-Signal empfängt, einen zweiten Eingang, der das Eingangsreset-Signal (LS_RESET) empfängt, im Falle der ersten Generierungsschaltung (6a), bzw. das negierte Eingangsreset-Signal im Falle der zweiten Generierungsschaltung (6b), einen dritten Eingang, der an den Ausgang des ersten logischen Gates (39a) gekoppelt ist, und einen Ausgang, der ein jeweiliges Boost-Signal bereitstellt.

12. Decoder-Stufe (44, 45) für eine Speichervorrichtung (100), die eine Speicheranordnung (42) aufweist, die eine Vielzahl von Speicherzellen (43) beinhaltet, die in Wortzeilen (WL) und Bit-Zeilen (BL) angeordnet sind, wobei die Decoder-Stufe (44, 45) konfiguriert ist, um die Wortzeilen (WL) und/oder Bit-Zeilen (BL) in Abhängigkeit von Adresssignalen (AS) auszuwählen und zu beeinflussen; wobei die Decoder-Stufe (44, 45) konfiguriert eine Vielzahl von Schiebermodulen umfasst, wobei jedes mindestens eine Pegelschieberschaltung (1) nach einem der vorstehenden Ansprüche beinhaltet.

13. Decoder-Stufe nach Anspruch 12, umfassend eine Vielzahl von Auswahltransistoren (46, 48, 50, 52), die betreibbar sind, um die Wortzeilen (WL) und Bit-Zeilen (BL) für Speichervorgänge auszuwählen, und Kaskode-Transistoren (49, 51, 53), die an die Auswahltransistoren gekoppelt sind; wobei die Pegelschieberschaltungen (1) konfiguriert sind, um ein jeweiliges Steuerungssignal (YN, YO, V_{PUP}, V_{PDOWN}) für die Steuerungsanschlüsse der Auswahltransistoren zu generieren, und/oder eine jeweilige Kaskode-Spannung (V_{CASC}, V_{CASCN}, V_{CASCP}) für die Gate-Anschlüsse der Kaskode-Transistoren.

14. Speichervorrichtung (100), die eine Speicheranordnung (42) mit Wortzeilen (WL) und Bit-Zeilen (BL) und eine Decoder-Stufe (44, 45) nach Anspruch 12 oder 13 beinhaltet, um die Wortzeilen und Bit-Zeilen entsprechend den Adresssignalen (AS) auszuwählen.

15. Speichervorrichtung nach Anspruch 14, die vom PCM-Typ ist.

## Revendications

1. Circuit de décalage de niveau (1), configuré pour décaler un signal d'entrée (LV_IN), commutant dans une première plage de tension, afin de générer au moins un premier signal de sortie (HV_OUT), commutant de façon correspondante dans une deuxième plage de tension, plus élevée que la première plage de tension, comprenant :
un cœur de verrouillage (10) ayant des bornes d'entrée et de sortie de verrouillage (L_IN, L_OUT) et ayant une ligne d'alimentation (LS_TOP) conçue pour être alimentée par une tension d'alimentation (V_{PH}) et une ligne de référence (LS_BOT) conçue pour être couplée à une tension de référence (SHIFTED_GND) ;
des éléments de couplage capacitif (13a-13b) couplés aux bornes d'entrée et de sortie de verrouillage du cœur de verrouillage (10) ;
un étage d'attaque (16) configuré pour polariser les éléments de couplage capacitif (13a-13b) avec des signaux de polarisation (CP1_BOT-CP4_BOT) générés sur la base du signal d'entrée, lesdits éléments de couplage capacitif (13a-13b) couplant capacitivement la borne d'entrée de verrouillage (L_IN) et la borne de sortie de verrouillage (L_OUT) à des lignes de sortie de l'étage d'attaque (16) transportant les signaux de polarisation (CP1_BOT-CP4_BOT) ; et
un étage de découplage (14, 15) configuré pour découpler la ligne d'alimentation (LS_TOP) d'avec la tension d'alimentation (V_{PH}) et la ligne de référence (LS_BOT) d'avec la tension de référence (SHIFTED_GND) durant une commutation du signal d'entrée,
**caractérisé en ce que** l'étage de découplage (14, 15) est attaqué par l'étage d'attaque (16), par l'intermédiaire des éléments de couplage capacitif (13a-13b), pour découpler la ligne d'alimentation (LS_TOP) d'avec la tension d'alimentation (V_{PH}) et la ligne de référence (LS_BOT) d'avec la tension de référence (SHIFTED_GND) durant une commutation du signal d'entrée.

2. Circuit de décalage de niveau selon la revendication 1, configuré en outre pour générer un deuxième signal de sortie (MV_OUT), commutant de façon correspondante dans une troisième plage de tension, intermédiaire entre la première plage de tension et la deuxième plage de tension ; dans lequel les premier et deuxième signaux de sortie (HV_OUT ; MV_OUT) ont des transitions de commutation correspondantes et simultanées.

3. Circuit de décalage de niveau selon la revendication 1 ou 2, dans lequel l'étage de découplage comprend une première unité de découplage (14), incluant une paire de transistors PMOS de découplage (14a, 14b) connectés entre la ligne d'alimentation (LS_TOP) et une ligne portée à la tension d'alimentation (V_{PH}) et ayant des bornes de commande attaquées par l'étage d'attaque (16) par l'intermédiaire des éléments de couplage capacitif (13a-13b), et une deuxième unité de découplage (15), incluant une paire de transistors NMOS de découplage (15a, 15b) connectés entre la ligne de référence (LS_BOT) et une ligne portée à la tension de référence (SHIFTED_GND) et ayant des bornes de commande respectives attaquées par l'étage d'attaque (16) par l'intermédiaire des éléments de couplage capacitif (13a-13b) ; dans lequel l'étage d'attaque (16) est configuré pour générer un premier et un deuxième signal de polarisation (CP1_BOT, CP2_BOT) avec des valeurs positives chevauchantes durant une commutation du signal d'entrée, afin d'attaquer les bornes de commande de la paire de transistors PMOS de découplage (14a, 14b) par l'intermédiaire d'éléments de couplage capacitif respectifs (13a-13b), et un troisième et un quatrième signal de polarisation (CP3_BOT, CP4_BOT) avec des valeurs négatives chevauchantes durant une commutation du signal d'entrée, afin d'attaquer les bornes de commande de la paire de transistors NMOS de découplage (15a, 15b) par l'intermédiaire d'éléments de couplage capacitif respectifs (13a-13b).

4. Circuit de décalage de niveau selon la revendication 3, dans lequel l'étage d'attaque (16) comprend une première et une deuxième unité d'attaque (16a, 16b), d'un type de logique NAND et, respectivement, NOR, incluant chacune une première (16a', 16b') et une deuxième (16a", 16b") porte logique, configurées pour fournir en sortie les signaux de polarisation (CP1_BOT-CP4_BOT) ; dans lequel les première et deuxième unités d'attaque (16a, 16b) sont configurées pour générer les premier et deuxième signaux de polarisation (CP1_BOT, CP2_BOT), respectivement les troisième et quatrième signaux de polarisation (CP3_BOT, CP4_BOT), ayant des valeurs opposées, sauf pendant un intervalle de chevauchement durant une commutation du signal d'entrée, durant lequel les premier et deuxième signaux de polarisation (CP1_BOT, CP2_BOT) ont les valeurs positives chevauchantes et les troisième et quatrième signaux de polarisation (CP3_BOT, CP4_BOT) ont les valeurs négatives chevauchantes ; la période de chevauchement étant fonction d'un temps de propagation de porte logique entre la première (16a', 16b') et la deuxième (16a", 16b") porte logique.

5. Circuit de décalage de niveau selon la revendication 4, dans lequel la première porte logique (16a', 16b') a une première entrée recevant une entrée de polarisation (P_IN) qui est fonction du signal d'entrée (LV_IN), une deuxième entrée couplée à la sortie de la deuxième porte logique (16a", 16b"), et une sortie fournissant un signal de polarisation respectif (CP1_BOT, CP3_BOT) ; et la deuxième porte logique (16a", 16b") a une première entrée respective recevant l'entrée de polarisation inversée, une deuxième entrée respective couplée à la sortie de la première porte logique (16a', 16b'), et une sortie respective fournissant un signal de polarisation respectif (CP2_BOT, CP4_BOT).

6. Circuit de décalage de niveau selon l'une quelconque des revendications 3-5, dans lequel le cœur de verrouillage (10) inclut une première unité de verrouillage (10a) et une deuxième unité de verrouillage (10b), ayant chacune une entrée de verrouillage (L_IN) et une sortie de verrouillage (L_OUT) ; dans lequel l'entrée et la sortie de verrouillage de la première unité de verrouillage (10a) sont couplées à une plaque supérieure d'un premier (C1), respectivement deuxième (C2), élément de couplage capacitif (13a, 13b) et aux bornes de commande des transistors PMOS de découplage (14a, 14b), et l'entrée et la sortie de verrouillage de la deuxième unité de verrouillage (10b) sont couplées à une plaque supérieure d'un troisième (C4), respectivement quatrième (C3), élément de couplage capacitif respectif (13a, 13b) et aux bornes de commande des transistors NMOS de découplage (15a, 15b) ; et dans lequel des plaques inférieures des premier et deuxième éléments de couplage capacitifs associés à la première unité de verrouillage (10a) sont couplées à l'étage d'attaque (16) pour recevoir les premier et deuxième signaux de polarisation (CP1_BOT, CP2_BOT), et des plaques inférieures des troisième et quatrième éléments de couplage capacitif associés à la deuxième unité de verrouillage (10b) sont couplées à l'étage d'attaque (16) pour recevoir les troisième et quatrième signaux de polarisation (CP3_BOT, CP4_BOT).

7. Circuit de décalage de niveau selon la revendication 6, comprenant une première sortie configurée pour fournir un signal de sortie décalé à niveau haut (HLS_OUT) pour la génération du premier signal de sortie (HV_OUT), et couplée à la plaque supérieure du quatrième élément de couplage capacitif (13b) associé à la sortie de verrouillage (L_OUT) de la deuxième unité de verrouillage (10b) par l'intermédiaire d'un étage inverseur (19) ayant pour référence la tension d'alimentation (V_{PH}) et la tension de référence (SHIFTED_GND) ; et une deuxième sortie configurée pour fournir un signal de sortie décalé à niveau moyen (MLS_OUT) pour la génération d'un deuxième signal de sortie (MV_OUT), commutant dans une troisième plage de tension intermédiaire entre la première et la deuxième plage de tension, couplée à la plaque inférieure dudit quatrième élément de couplage capacitif (13b) associé à la sortie de verrouillage (L_OUT) de la deuxième unité de verrouillage (10b) par l'intermédiaire d'un tampon inverseur (22) ; dans lequel les premier et deuxième signaux de sortie (MV_OUT, HV_OUT) ont des transitions de commutation correspondantes et simultanées.

8. Circuit de décalage de niveau selon l'une quelconque des revendications précédentes, comprenant en outre : un étage de génération de réinitialisation (6) configuré pour générer un premier et un deuxième signal de réinitialisation à niveau décalé (LS_RESET_P, LS_RESET_N) au niveau d'une première et d'une deuxième sortie de réinitialisation, afin d'initialiser le cœur de verrouillage (10), sur la base d'un signal de réinitialisation d'entrée (LS_RESET) et d'un signal de cadencement (CK) ; un premier transistor de réinitialisation (20a), du type PMOS, couplé entre la ligne d'alimentation (LS_TOP) et une première borne de sortie de verrouillage (L_OUT) du cœur de verrouillage (10) et ayant une borne de commande recevant le premier signal de réinitialisation à niveau décalé (LS_RESET_P) ; et un deuxième transistor de réinitialisation (20b), du type NMOS, couplé entre la ligne de référence (LS_BOT) et une deuxième borne de sortie de verrouillage (L_OUT) du cœur de verrouillage (10) et ayant une borne de commande recevant le deuxième signal de réinitialisation à niveau décalé (LS_RESET_N).

9. Circuit de décalage de niveau selon la revendication 8, dans lequel l'étage de génération de réinitialisation (6) comprend un premier circuit de génération (6a), pour la génération du premier signal de réinitialisation à niveau décalé (LS_RESET_P), et un deuxième circuit de génération (6b), pour la génération du deuxième signal de réinitialisation à niveau décalé (LS_RESET_N) ; dans lequel chacun des premier et deuxième circuits de génération (6a, 6b) inclut : un condensateur de stockage respectif (30), ayant une plaque inférieure recevant le signal de réinitialisation d'entrée (LS_RESET) dans le cas du premier circuit de génération (6a), respectivement le signal de réinitialisation d'entrée inversé dans le cas du deuxième circuit de génération (6b), et une plaque supérieure couplée à la première, respectivement deuxième, sortie de réinitialisation par l'intermédiaire d'un tampon de sortie respectif (36) ayant une première entrée d'alimentation recevant la tension d'alimentation (V_{PH}) et une deuxième entrée d'alimentation recevant une tension intermédiaire (V_{PL}), inférieure à la tension d'alimentation (V_{PH}) ; une unité de rafraîchissement (32), alimentée par la tension d'alimentation (V_{PH}) dans le cas du premier circuit de génération (6a), respectivement la tension intermédiaire (V_{PL}) dans le cas du deuxième circuit de génération (6b), et configurée pour rafraîchir une tension de la plaque supérieure du condensateur de stockage (30) à la valeur de la tension d'alimentation (V_{PH}), respectivement à la valeur de la tension intermédiaire (V_{PL}), de façon continue à chaque cycle du signal d'horloge (CK) si le signal de réinitialisation (LS_RESET) est dans un état inactif, et pour arrêter de rafraîchir le condensateur de stockage (30) si le signal de réinitialisation (LS_RESET) commute vers l'état actif.

10. Circuit de décalage de niveau selon la revendication 9, dans lequel l'unité de rafraîchissement (32) inclut au moins un premier (38a) et un deuxième (38b) transistor de rafraîchissement qui sont, dans le cas du premier circuit de génération (6a), du type PMOS et couplés entre la tension d'alimentation (V_{PH}) et la plaque supérieure du condensateur de stockage respectif (30), et dans le cas du deuxième circuit de génération (6b), du type NMOS et couplés entre la tension intermédiaire (V_{PL}) et la plaque supérieure du condensateur de stockage respectif (30) ; et dans lequel chacun des premier et deuxième circuits de génération (6a, 6b) inclut en outre : un premier et un deuxième condensateur de renforcement (33, 34), ayant une plaque supérieure couplée à la borne de commande du premier (38a), respectivement deuxième (38b), transistor de rafraîchissement ; et une unité de renforcement (35), couplée à une plaque inférieure des premier et deuxième condensateurs de renforcement (33, 34), configurée pour attaquer ladite plaque inférieure avec des signaux de renforcement de niveaux opposés à chaque cycle du signal de cadencement (CK) si le signal de réinitialisation d'entrée (LS_RESET) est dans un état inactif, et avec des signaux de renforcement d'un même niveau, de manière à mettre à l'état bloqué aussi bien le premier que le deuxième transistor de rafraîchissement (38a, 38b), lorsque le signal de réinitialisation d'entrée (LS_RESET) commute vers l'état actif.

11. Circuit de décalage de niveau selon la revendication 10, dans lequel l'unité de renforcement (35) est d'un type de logique NAND dans le cas du premier circuit de génération (6a), respectivement du type de logique NOR dans le cas du deuxième circuit de génération (6b), et inclut une première (39a) et une deuxième (39b) porte logique, configurées pour fournir en sortie les signaux de renforcement ; dans lequel la première porte logique (39a) a une première entrée recevant le signal de cadencement (CK), une deuxième entrée recevant le signal de réinitialisation d'entrée (LS_RESET) dans le cas du premier circuit de génération (6a), respectivement le signal de réinitialisation d'entrée inversé dans le cas du deuxième circuit de génération (6b), une troisième entrée couplée à la sortie de la deuxième porte logique (39b), et une sortie fournissant un signal de renforcement respectif ; et la deuxième porte logique (39b) a une première entrée respective recevant le signal de cadencement inversé, une deuxième entrée recevant le signal de réinitialisation d'entrée (LS_RESET) dans le cas du premier circuit de génération (6a), respectivement le signal de réinitialisation d'entrée inversé dans le cas du deuxième circuit de génération (6b), une troisième entrée couplée à la sortie de la première porte logique (39a), et une sortie fournissant un signal de renforcement respectif.

12. Étage décodeur (44, 45) pour un dispositif de mémoire (100) ayant une matrice de mémoire (42) incluant une pluralité de cellules de mémoire (43) agencées dans des lignes de mot (WL) et des lignes de bit (BL), l'étage décodeur (44, 45) étant configuré pour sélectionner et polariser les lignes de mot (WL) et/ou les lignes de bit (BL) en fonction de signaux d'adresse (AS) ; ledit étage décodeur (44, 45) comprenant une pluralité de modules de décalage, incluant chacun au moins un circuit de décalage de niveau (1) selon l'une quelconque des revendications précédentes.

13. Étage décodeur selon la revendication 12, comprenant une pluralité de transistors de sélection (46, 48, 50, 52), qui servent à sélectionner lesdites lignes de mot (WL) et/ou lesdites lignes de bit (BL) pour des opérations de mémoire, et des transistors cascode (49, 51, 53), couplés aux transistors de sélection ; dans lequel les circuits de décalage de niveau (1) sont configurés pour générer un signal de commande respectif (YN, YO, V_{PUP}, V_{PDOWN}) pour les bornes de commande desdits transistors de sélection et/ou une tension de cascode respective (V_{CASC}, V_{CASCN}, V_{CASCP}) pour les bornes de grille desdits transistors cascode.

14. Dispositif de mémoire (100), incluant une matrice de mémoire (42) dotée de lignes de mot (WL) et de lignes de bit (BL) et un étage décodeur (44, 45) selon la revendication 12 ou 13, pour sélectionner les lignes de mot et les lignes de bit selon des signaux d'adresse (AS).

15. Dispositif de mémoire selon la revendication 14, qui est d'un type PCM.
